(19) Europäisches Patentamt
European Patent Office
Office européen des brevets

(11) **EP 2 342 574 B1**

(12) **EUROPÄISCHE PATENTSCHRIFT**

(45) Veröffentlichungstag und Bekanntmachung des Hinweises auf die Patenterteilung:
**31.07.2013 Patentblatt 2013/31**

(21) Anmeldenummer: **08874998.1**

(22) Anmeldetag: **27.10.2008**

(51) Int Cl.:
**G01R 31/08** *(2006.01)*    **H02H 3/40** *(2006.01)*

(86) Internationale Anmeldenummer:
**PCT/EP2008/009189**

(87) Internationale Veröffentlichungsnummer:
**WO 2010/048972 (06.05.2010 Gazette 2010/18)**

(54) **FEHLERORTUNG IN ELEKTRISCHEN ENERGIEVERSORGUNGSNETZEN NACH DEM DISTANZSCHUTZPRINZIP**

FAULT LOCATION IN ELECTRICAL POWER SUPPLY GRIDS USING THE DISTANCE PROTECTION PRINCIPLE

LOCALISATION D'UN DÉFAUT DANS DES RÉSEAUX DE DISTRIBUTION D'ÉNERGIE ÉLECTRIQUE SELON LE PRINCIPE DE LA PROTECTION À DISTANCE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(43) Veröffentlichungstag der Anmeldung:
**13.07.2011 Patentblatt 2011/28**

(73) Patentinhaber: **Siemens Aktiengesellschaft 80333 München (DE)**

(72) Erfinder:
• **BÖHME, Klaus**
  **12305 Berlin (DE)**
• **KRAMER, Christian**
  **91452 Wilhermsdorf (DE)**
• **STÄHLE, Samuel, Thomas**
  **90459 Nürnberg (DE)**

(56) Entgegenhaltungen:
**EP-A- 1 739 441**

**Beschreibung**

Die Erfindung betrifft ein Verfahren zum Orten eines Erdfehlers auf einem Abschnitt einer elektrischen Energieversorgungsleitung nach dem Distanzschutzprinzip, wobei beim Auftreten eines Erdfehlers auf dem Abschnitt ein den in dem Abschnitt fließenden Strom angebender Strommesswert erfasst wird, ein die an dem Abschnitt anliegende Spannung angebender Spannungsmesswert erfasst wird sowie ein den entlang des Abschnitts fließenden Erdstrom angebender Erdstrommesswert erfasst wird und mit den erfassten Messwerten ein Fehlerortwert berechnet wird, der den Ort des Erdfehlers auf dem Abschnitt angibt, wobei dieser Fehlerortwert unter Verwendung der Leitungsimpedanz des Abschnitts und der Erdimpedanz des entlang des Abschnitts verlaufenden Erdreiches gebildet wird.

Die Erfindung betrifft auch ein elektrisches Distanzschutzgerät zur Erfassung und Ortung von Erdfehlern auf einen Abschnitt einer elektrischen Energieübertragungsleitung mit einer Messwerterfassungseinrichtung zum Erfassen von Strom- und Spannungsmesswerten sowie Erdstrommesswerten, die Werte des in dem Abschnitt fließenden Stromes und der an diesem anliegenden Spannung sowie des entlang des Abschnitts fließenden Erdstromes angeben, und einer Steuereinrichtung, die mit den erfassten Messwerten einen Fehlerortwert berechnet, der den Ort des Erdfehlers auf dem Abschnitt angibt, wobei dieser Fehlerortwert unter Verwendung der Leitungsimpedanz des Abschnitts und der Erdimpedanz des entlang des Abschnitts verlaufenden Erdreiches gebildet wird.

Zur Überwachung und zum Schutz elektrischer Energieversorgungsnetze werden üblicherweise sogenannte elektrische Schutzgeräte verwendet. Ein elektrisches Schutzgerät nimmt an einer Messstelle des elektrischen Energieversorgungsnetzes Messwerte auf, die einen Betriebszustand des elektrischen Energieversorgungsnetzes charakterisieren. Hierbei kann es sich beispielsweise um Strom- und Spannungsmesswerte handeln. Anhand dieser Messwerte und unter Verwendung spezieller Schutzalgorithmen trifft das Schutzgerät eine Entscheidung darüber, ob sich der von ihm überwachte Teil des elektrischen Energieversorgungsnetzes in einem zulässigen oder einem unzulässigen Betriebszustand befindet. Ein unzulässiger Betriebszustand liegt beispielsweise dann vor, wenn in dem überwachten Teil des elektrischen Energieversorgungsnetzes ein Kurzschluss aufgetreten ist. Liegt ein unzulässiger Betriebszustand vor, dann gibt das Schutzgerät üblicherweise automatisch einen sogenannten "Trip-Befehl" an einen ihm zugeordneten Leistungsschalter ab, der als Reaktion auf den Trip-Befehl seine Schaltkontakte öffnet und damit den fehlerbehafteten Abschnitt vom restlichen Energieversorgungsnetz abtrennt.

Ein häufig eingesetztes elektrisches Schutzgerät ist beispielsweise ein sogenanntes Distanzschutzgerät. Ein Distanzschutzgerät misst an einer Messstelle einer elektrischen Energieversorgungsleitung auftretende Ströme und Spannungen und berechnet daraus einen Impedanzwert der elektrischen Energieversorgungsleitung. Anhand des berechneten Impedanzwertes kann beispielsweise unter Zuhilfenahme bestimmter Auslösekennlinien überprüft werden, ob ein Fehler, wie z.B. ein Kurzschluss, auf der elektrischen Energieversorgungsleitung aufgetreten ist. Liegt ein Fehler vor, so gibt das Distanzschutzgerät einen Trip-Befehl an einen ihm zugeordneten Leistungsschalter ab, der daraufhin den fehlerbehafteten Abschnitt der elektrischen Energieversorgungsleitung von dem übrigen Energieversorgungsnetz abtrennt. Zusätzlich gibt ein Distanzschutzgerät auch den Ort des auf der überwachten Energieübertragungsleitung aufgetretenen Fehlers an. Distanzschutzgeräte werden häufig zur Überwachung von elektrischen Energieversorgungsleitungen eingesetzt, weil sie eine hohe Selektivität aufweisen und in der Lage sind, autonome Entscheidungen zu treffen, ohne dass hierzu eine Kommunikation mit einem anderen Schutzgerät notwendig ist.

Kurzschlüsse können beispielsweise zwischen zwei oder drei Phasen der Energieübertragungsleitung (ein sogenannter "Leiter-Leiter-Kurzschluss") oder zwischen einer jeweiligen Phase und der elektrischen Erde (ein sogenannter "Leiter-Erde-Kurzschluss") auftreten. Im Falle eines Leiter-Leiter-Kurzschlusses zwischen zwei oder drei Phasen der elektrischen Energieversorgungsleitung kann die Erkennung und Ortung des Kurzschlusses sehr leicht erfolgen, da die zur Bestimmung eines Impedanzschwellenwertes benötigten Leistungsimpedanzen der von dem Fehler betroffenen Leitungen üblicherweise bekannt sind.

Wesentlich häufiger als Leiter-Leiter-Kurzschlüsse treten jedoch Leiter-Erde-Kurzschlüsse auf, wobei es sich im Wesentlichen um einphasige Kurzschlüsse mit Erdbeteiligung handelt. Zur Ortung solcher Leiter-Erde-Kurzschlüsse ist die Kenntnis der Erdimpedanz des Erdreiches entlang des überwachten Abschnitts der Energieübertragungsleitung notwendig, da dieses an der Impedanz der von dem Distanzschutzgerät gemessenen Leiter-Erde-Schleife maßgeblich beteiligt ist.

Der für die Erdimpedanz verwendete Einstellwert, der als Parameter in dem elektrischen Distanzschutzgerät eingestellt werden muss, wird üblicherweise als fester Einstellwert des Distanzschutzgerätes vorgegeben. Der Wert kann hierbei entweder aus Parametern der elektrischen Energieversorgungsleitung, wie beispielsweise der Nullsystemimpedanz und der Mitsystemimpedanz der elektrischen Energieversorgungsleitung, abgeleitet oder aber explizit gemessen werden.

Ein die Erdimpedanz nutzendes Verfahren zum Orten eines Erdfehlers ist beispielsweise aus der EP 1 739 441 A1 bekannt.

Der Wert der Erdimpedanz kann allerdings auch dynamisch festgelegt werden. Hierzu ist aus der früheren Patentanmeldung der Anmelderin PCT/EP2007/006703 bekannt, Umgebungsparameter, von denen die Erdimpedanz abhängt, mittels an ein Distanzschutzgerät angeschlossenen Sensoren direkt zu messen. Hierdurch kann die Genauigkeit einer Fehlerortung erhöht werden.

Der Erfindung liegt die Aufgabe zugrunde, ein Verfahren der oben genannten Art anzugeben, das eine noch genauere Ortung eines aufgetretenen Erdfehlers ermöglicht. Eine weitere Aufgabe besteht darin, ein entsprechendes Distanzschutzgerät anzugeben.

Hinsichtlich des Verfahrens wird diese Aufgabe durch ein gattungsgemäßes Verfahren gelöst, bei dem der Wert der zur Bildung des Fehlerortwertes verwendeten Erdimpedanz dynamisch festgelegt wird, wobei zur dynamischen Festlegung des Wertes der Erdimpedanz eine Modellbeschreibung herangezogen wird, die zumindest zwei Einflussfaktoren auf die Erdimpedanz berücksichtigt und den Verlauf des Wertes der Erdimpedanz über die gesamte Länge des Abschnitts angibt.

Der wesentliche Vorteil des erfindungsgemäßen Verfahrens besteht darin, dass zur Bestimmung der Erdimpedanz nicht nur einzelne punktuelle - meist in der Nähe des Distanzschutzgerätes aufgenommene - Messwerte von Einflussfaktoren verwendet werden, sondern stattdessen ein vollständiger Verlauf dieser Einflussfaktoren entlang des Abschnitts der Energieversorgungsleitung herangezogen wird. Der Wert der Einflussgrößen und damit der jeweiligen Erdimpedanz schwankt nämlich üblicherweise entlang des Abschnitts. Durch die Betrachtung von zumindest zwei Einflussfaktoren kann die Bestimmung der Erdimpedanz zudem noch genauer durchgeführt werden, als bei Betrachtung eines einzelnen Einflussfaktors.

Konkret kann gemäß einer vorteilhaften Ausführungsform des erfindungsgemäßen Verfahrens vorgesehen sein, dass als Einflussfaktoren zumindest zwei Parameter aus folgender Auflistung verwendet werden: eine Luftfeuchtigkeit, eine Lufttemperatur, ein Ionisierungsgrad der Luft, eine Feuchtigkeit des betroffenen Erdreiches, eine Temperatur des betroffenen Erdreiches, eine Bodenbeschaffenheit des betroffenen Erdreiches, ein Abstand des Abschnitts vom Erdreich. Diese Parameter stellen nämlich die Haupteinflussfaktoren dar, die Veränderungen der Erdimpedanz des Erdreiches entlang des Abschnitts der Energieversorgungsleitung hervorrufen.

Eine weitere vorteilhafte Ausführungsform des erfindungsgemäßen Verfahrens sieht außerdem vor, dass die zumindest zwei verwendeten Einflussfaktoren gemessen und/oder berechnet werden. Eine Messung kann über verteilt angeordnete Sensoren erfolgen. Zwischen einzelnen Sensoren kann der Wert des jeweiligen Einflussfaktors z.B. durch Interpolation berechnet werden. Eine Berechung ist außerdem durch Ableitung des Wertes des gesuchten Einflussfaktors aus anderen Größen möglich, z.B. bei einer Bestimmung der Feuchtigkeit des Erdreichs anhand von vergangenen Niederschlagsmengen.

Eine weitere vorteilhafte Ausführungsform des erfindungsgemäßen Verfahrens sieht zudem vor, dass die zumindest zwei verwendeten Einflussfaktoren aus zumindest einer Datenbank entnommen werden, wobei die zumindest eine Datenbank eine Zuordnung von geografischen Positionswerten zu den jeweiligen Werten der Einflussfaktoren enthält. Solche Datenbanken stehen häufig für verschiedenste Anwendungen zur Verfügung und müssen nicht gesondert für die Bestimmung der Erdimpedanz erzeugt werden.

Vorteilhafterweise kann in diesem Zusammenhang vorgesehen sein, dass die in der zumindest einen Datenbank enthaltenen Werte der Einflussfaktoren in Echtzeit an die tatsächlichen Bedingungen angepasst werden.

Um möglichst einfach die benötigten Werte der Einflussfaktoren auszuwählen, kann außerdem vorgesehen sein, dass die Modellbeschreibung durch Auswahl solcher Werte der Einflussfaktoren gebildet wird, die denjenigen geografischen Positionswerten zugeordnet sind, entlang denen sich der Abschnitt erstreckt. Hierbei müssen lediglich anhand derjenigen Positionswerte, die den Verlauf des Abschnitts der Energieversorgungsleitung beschreiben, die passenden Werte der Einflussfaktoren aus der Datenbank ausgelesen werden.

Konkret kann es sich bei der zumindest einen Datenbank beispielsweise um ein Geoinformationssystem und/ oder eine Wetterdatenbank handeln.

Eine weitere vorteilhafte Ausführungsform des erfindungsgemäßen Verfahrens sieht außerdem vor, dass die Modellbeschreibung von einer entfernten Datenverarbeitungseinrichtung gebildet wird und von der entfernten Datenverarbeitungseinrichtung einer Steuereinrichtung eines Distanzschutzgerätes bereitgestellt wird, die den Fehlerortwert berechnet. Hierdurch kann die Modellbeschreibung von der entfernten Datenverarbeitungseinrichtung berechnet werden, bei der es sich z.B. um einen vergleichsweise leistungsstarken PC in einer Netzleitstelle handeln kann. Die Fehlerortung anhand der berechneten Modellbeschreibung für die Erdimpedanz kann dann von der Steuereinrichtung eines Distanzschutzgerätes durchgeführt werden. Solche Steuereinrichtungen stellen üblicherweise nicht die hohe Rechenkapazität zur Verfügung, die ein PC einer Netzleitstelle bereithält.

Um nicht unnötigerweise große Datenmengen zwischen der entfernten Datenverarbeitungseinrichtung und der Steuereinrichtung zu übertragen und dabei die Kommunikationslast auf einer dazwischen vorhandenen Kommunikationsverbindung zu steigern, wird gemäß einer weiteren vorteilhaften Ausführungsform in diesem Zusammenhang vorgeschlagen, dass die Modellbeschreibung erst dann von der entfernten Datenverarbeitungseinrichtung an die Steuereinrichtung übertragen wird, wenn die Steuereinrichtung die Modellbeschreibung anfordert.

Diesbezüglich kann beispielsweise vorgesehen sein, dass die Steuereinrichtung die Modellbeschreibung nach dem Auftreten eines Fehlers auf dem Abschnitt anfordert, da erst dann eine sinnvolle Fehlerortung durchgeführt werden kann.

Alternativ zu einer Berechnung der Modellbeschreibung mittels einer ersten Datenverarbeitungseinrichtung kann aber auch vorgesehen sein, dass ein Distanzschutzgerät, das an dem Abschnitt angeordnet ist, die zumindest zwei verwendeten Einflussfaktoren von der zumindest einen Datenbank empfängt und eine Steuereinrichtung des Distanzschutzgerätes anhand der empfangenen Einflussfaktoren die Modellbeschreibung bildet. Dies bietet sich insbesondere bei einem Distanzschutzgerät mit hoher Rechenleistung an, dass über einen Kommunikationsanschluss, z.B. einen Kommunikationsanschluss mit Internetanbindung, direkt mit einer oder mehreren entsprechenden Datenbanken in Verbindung steht.

Hinsichtlich des elektrischen Distanzschutzgerätes wird die oben genannte Aufgabe durch ein Distanzschutzgerät der eingangs genannten Art gelöst, bei dem die Steuereinrichtung zur Durchführung eines Verfahrens gemäß einer der vorangehend beschriebenen Ausführungsformen eingerichtet ist.

Die Erfindung wird im Folgenden anhand von Ausführungsbeispielen näher dargestellt. Hierzu zeigen

Figur 1     eine schematische Darstellung eines Distanzschutzgerätes an einer dreiphasigen Energieübertragungsleitung,

Figur 2     ein schematisches Ablaufbild zur Erläuterung der Bestimmung einer Modellbeschreibung zur Angabe der Erdimpedanz,

Figur 3     eine schematische Darstellung eines Distanzschutzgerätes, das mit einer entfernten Datenverarbeitungseinrichtung in Kommunikationsverbindung steht und

Figur 4     eine schematische Darstellung eines Distanzschutzgerätes, das direkt mit zwei Datenbanken in Kommunikationsverbindung steht.

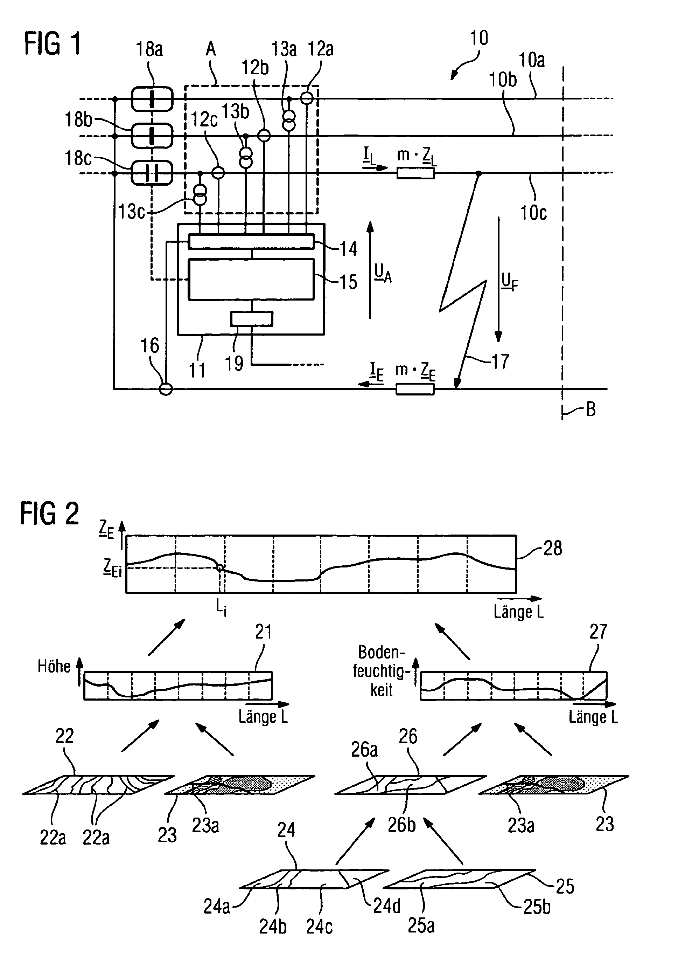

Figur 1 zeigt einen Abschnitt 10 einer im Weiteren nicht näher dargestellten geerdeten dreiphasigen elektrischen Energieübertragungsleitung. Der Abschnitt 10 ist auf seiner einen Seite durch eine Messstelle A eines Distanzschutzgerätes 11 begrenzt. Auf seiner anderen Seite wird der Abschnitt 10 durch eine gestrichelte Linie B begrenzt, die beispielsweise eine Messstelle eines weiteren Distanzschutzgerätes, das in Figur 1 nicht näher dargestellt ist, kennzeichnet. Der durch die Messstelle A und die gestrichelte Linie B begrenzte Abschnitt 10 der dreiphasigen elektrischen Energieübertragungsleitung wird von dem elektrischen Distanzschutzgerät 11 auf unzulässige Betriebszustände, wie beispielsweise Kurzschlüsse, überwacht. Hierzu werden an den jeweiligen Phasen 10a, 10b und 10c des Abschnitts 10 mittels lediglich schematisch dargestellter Stromwandler 12a, 12b und 12c sowie Spannungswandler 13a, 13b und 13c Strom- und Spannungsmesswerte der elektrischen Energieübertragungsleitung aufgenommen und einer Messwerterfassungseinrichtung 14 des Distanzschutzgerätes 11 zugeführt. Außerdem wird der Messwerterfassungseinrichtung 14 ein mit einem weiteren (ebenfalls an Messstelle A angeordneten) Stromwandler 16 erfasster Erdstrommesswert zugeführt.

In der Messwerterfassungseinrichtung 14 findet üblicherweise eine Transformierung von den immer noch vergleichsweise hohen Strom- bzw. Spannungsniveaus der ausgangsseitig von den Stromwandlern 12a, 12b und 12c sowie 16 bzw. Spannungswandlern 13a, 13b und 13c abgegebenen Ströme bzw. Spannungen auf von dem Distanzschutzgerät 11 verarbeitbare Strom- bzw. Spannungsniveaus statt. Außerdem finden in der Messwerterfassungseinrichtung üblicherweise eine Analog-Digital-Wandlung und ggf. weitere Vorverarbeitungsschritte, wie z.B. eine Filterung der empfangenen Messwerte, statt. Sollen die Messwerte in Form von Strom- bzw. Spannungszeigern weiter verarbeitet werden, so findet in der Messwerterfassungseinrichtung üblicherweise auch eine Strom- bzw. Spannungszeigerbildung statt, so dass die gebildeten Strom- bzw. Spannungszeiger dann über Informationen hinsichtlich Amplitude und Phasenlage von Strom und Spannung der einzelnen Phasen 10a, 10b und 10c des Abschnitts 10 der elektrischen Energieübertragungsleitung bzw. des Erdstromes verfügen.

Die mit der Messwerterfassungseinrichtung 14 erfassten und ggf. vorverarbeiteten Messwerte von Strom und Spannung werden dann einer Steuereinrichtung 15 des Distanzschutzgerätes 11 zugeführt. Die Steuereinrichtung 15 bestimmt anhand dem Fachmann hinlänglich bekannter Algorithmen, ob ein Fehler auf dem Abschnitt 10 der elektrischen Energieübertragungsleitung vorliegt und erkennt außerdem die fehlerbehaftete Schleife (z.B. eine Leiter-Leiter-Schleife zwischen Phasen 10a und 10b oder eine Leiter-Erde-Schleife zwischen Phase 10c und Erde). Wenn die Steuereinrichtung 15 einen solchen Fehler erkennt, gibt sie entsprechende TRIP-Signale an den einzelnen Phasen 10a, 10b, 10c zugeordnete Leistungsschalter 18a, 18b, 18c ab, um die von dem Fehler betroffene(n) Phase(n) von der übrigen Energieversorgungsleitung abzutrennen.

Im Anschluss daran berechnet die Steuereinrichtung 15 anhand der gemessenen Strom, Erdstrom- und Spannungsmesswerte einen Fehlerortwert, der den Ort des Fehlers auf dem Abschnitt 10 (meistens relativ zur Leitungslänge des Abschnitts 10) angibt. Hierzu werden die Leiterimpedanzen der jeweiligen Phasen und - bei Erdfehlern - die Erdimpedanz des entlang des Abschnittes verlaufenden Erdreiches benötigt. Im Folgenden soll näher auf die Ortung eines Erdfehlers eingegangen werden.

Gemäß Figur 1 sei angenommen, dass ein Kurzschluss 17 zwischen der Phase 10c und Erde aufgetreten ist. Hierdurch wird eine sogenannte Leiter-Erde-Schleife zwischen der Phase 10c (dem Leiter) und der Erde erzeugt, die von der Messstelle A über die Phase 10c bis zur Stelle des Kurzschlusses 17 und von dort wieder zurück über die Erde zur Messstelle A bzw. dem Einbauort des Stromwandlers 16 verläuft.

Für die weitere Erläuterung soll zunächst anhand von Figur 1 die Berechnung eines Fehlerortwertes m durch die Steuereinrichtung 15 des Distanzschutzgerätes 11 hergeleitet werden. Dieser Fehlerortwert m gibt - bezogen auf die gesamte Länge des überwachten Abschnitts 10 - denjenigen Ort an, an dem der Kurzschluss 17 zwischen der Phase 10c und Erde aufgetreten ist. Dieser Ort wird benötigt, um etwaige Schäden an der Energieversorgungsleitung reparieren und die Fehlerursache beheben zu können.

Zur Berechung des Fehlerortwertes m wird die bekannte Maschenregel gemäß dem zweiten Kirchhoffschen Gesetz auf die in Figur 1 durch den Kurzschluss 17 zwischen der Messstelle A erzeugte Leiter-Erde-Schleife angewendet. Hieraus ergibt sich die folgende Maschengleichung:

$$-\underline{U}_A + \underline{I}_L \cdot m \cdot \underline{Z}_L + \underline{U}_F + \underline{I}_E \cdot m \cdot \underline{Z}_{E,ges} = 0 \qquad (1)$$

Hierbei bedeuten die Formelzeichen (vergleiche auch Figur 1):

$\underline{U}_A$: den von dem Distanzschutzgerät 11 gemessenen Spannungszeiger, der die Spannung zwischen der Phase 10c und Erde angibt;

$\underline{I}_L$: den von dem Distanzschutzgerät 11 gemessenen Stromzeiger, der den in der Phase 10c fließenden Strom angibt;

m: die Entfernung von der Messstelle A zum Fehlerort des Kurzschlusses 17 bezogen auf die gesamte Länge des Abschnitts 10 (Fehlerortwert);

$\underline{Z}_L$: die Mitsystemimpedanz der Phase 10c;

$\underline{U}_F$: den Spannungsabfall am Fehlerort;

$\underline{I}_E$: den von dem Distanzschutzgerät 11 gemessenen Erdstromzeiger, der den in der Erde fließenden Strom angibt; und

$\underline{Z}_{E,ges}$: die gesamte Erdimpedanz entlang des Abschnitts 10 der Energieversorgungsleitung.

Unter Verwendung dieser Gleichung (1) kann die Steuereinrichtung 15 des Distanzschutzgerätes 11 bei Kenntnis der Werte für die Leitungsimpedanz und die Erdimpedanz den Fehlerortwert m bestimmen, da die entsprechenden Strom-, Erdstrom- und Spannungsmesswerte durch Messung zum Zeitpunkt des Kurzschlusses bekannt sind. Der Wert des Spannungsabfalls $U_F$ an der Fehlerstelle kann üblicherweise bei einer einseitigen Fehlerortung nicht bestimmt werden. Er kann aber ohne zu großen Einfluss auf das Endergebnis vernachlässigt werden.

Obwohl in Gleichung (1) Messwerte von Strom, Erdstrom und Spannung als Zeiger dargestellt sind und folglich Informationen über Amplitude und Phasenlage umfassen, ist das beschriebene Verfahren auch mit skalaren Größen (Amplituden, rms-Werten, Effektivwerten) durchführbar.

Während die Leitungsimpedanz $\underline{Z}_L$ der Phase 10c weitestgehend konstant und unabhängig von äußeren Einflüssen ist, verändert sich der Wert der Erdimpedanz $\underline{Z}_{E,ges}$ in Abhängigkeit von Einflussfaktoren, wie beispielsweise Temperatur und Feuchtigkeit. So besitzt beispielsweise ein mit Feuchtigkeit durchtränktes Erdreich eine geringere Impedanz als ein trockener Boden. Außerdem kann die Erdimpedanz auch abhängig von der Luftfeuchtigkeit, der Lufttemperatur, dem Ionisierungsgrad der Luft, der Temperatur des betroffenen Erdreiches, der Bodenbeschaffenheit des betroffenen Erdreiches und dem Abstand des Abschnitts 10 der elektrischen Energieversorgungsleitung vom Boden sein.

Unter Berücksichtigung zumindest zweier Einflussfaktoren, die den Wert der Erdimpedanz entlang des Abschnitts 10 der elektrischen Energieversorgungsleitung beeinflussen, kann nun eine Modellbeschreibung erzeugt werden, die den Wert der Erdimpedanz an jeder Stelle entlang des Abschnitts 10 der elektrischen Energieversorgungsleitung angibt. Der in dem Distanzschutzgerät 11 schließlich zu berücksichtigende Wert $\underline{Z}_{E,ges}$ der Erdimpedanz setzt sich dann zusammen, aus den partiellen Erdimpedanzen Z1 bis Zn gemäß Gleichung 2:

$$\underline{Z}_E = \sum_{n=1}^{L} \underline{Z}_n \qquad\qquad (2),$$

wobei

$\underline{Z}_n$ : partielle Erdimpedanz,

n : Laufvariable,

L : Laufvariable bei vollständiger Länge des Abschnitts 10,

und wobei jede partielle Erdimpedanz $Z_n$ durch die Modellbeschreibung angegeben wird. Die Modellbeschreibung selbst wird anhand der zumindest zwei verwendeten Einflussfaktoren an den einzelnen - beliebig klein gewählten - Streckenabschnitten n bis L des Abschnitts 10 der elektrischen Energieversorgungsleitung bestimmt.

Die Steuereinrichtung 15 des Distanzschutzgerätes 11 kann unter Verwendung der durch die Modellbeschreibung angegebenen Erdimpedanz $\underline{Z}_E$ durch einfache Anwendung von Gleichung (1) den Fehlerortwert n mit großer Genauigkeit bestimmen.

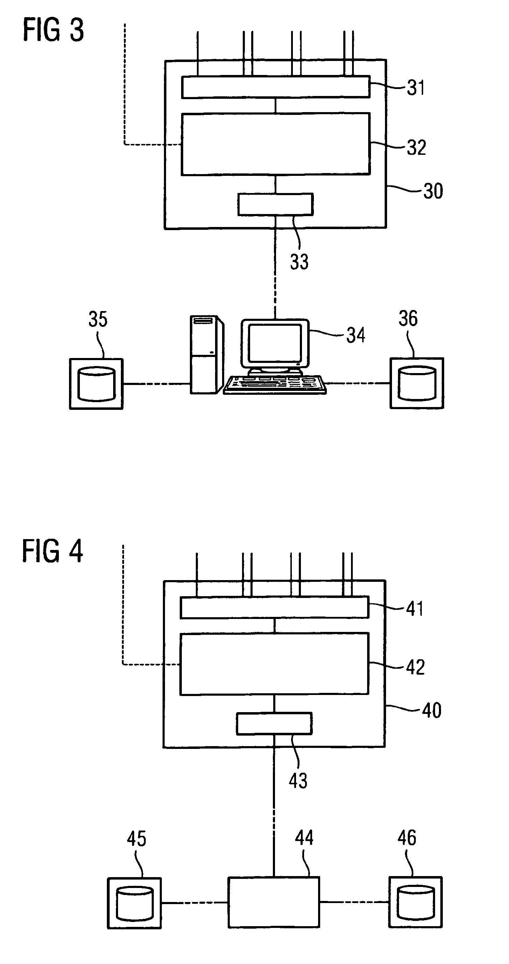

Damit der Steuereinrichtung 15 des Distanzschutzgerätes 11 die Modellbeschreibung bereitgestellt werden kann, weist das Distanzschutzgerät 11 eine Kommunikationseinrichtung 19 auf. Näheres hierzu wird im Zusammenhang mit Figuren 3 und 4 erläutert.

Anhand von Figur 2 soll beispielhaft die Bildung einer Modellbeschreibung 28 für die Erdimpedanz entlang des Abschnitts der elektrischen Energieversorgungsleitung erläutert werden. Zur Bildung der Modellbeschreibung 28 werden die Werte zumindest zweier der oben genannten Einflussfaktoren entlang des Abschnitts verwendet. Solche Werte werden üblicherweise in einer oder mehreren Datenbanken vorgehalten, in denen positionsgenau der Wert der einzelnen Einflussfaktoren angegeben ist, d.h. jedem Wert eines Einflussfaktors ist ein geographischer Positionswert (z.B. durch Angabe einer geografischen Länge und Breite) zugeordnet. Beispiele solcher Datenbanken sind beispielsweise Geoinformationssysteme, die Angaben über Topologie und Bodenbeschaffenheit sowie das Vorhandensein von Wäldern, Wasserläufen, Bebauung etc. angeben, oder Wetterdatenbanken, die Informationen über Niederschläge, Temperaturen, Luftfeuchtigkeit, Sonneneinstrahlung etc. bereithalten. Sollten sich die Werte bestimmter Einflussfaktoren, (beispielsweise eine Bodenfeuchtigkeit) nicht direkt aus einer der angebotenen Datenbanken auslesen lassen, so können diese unter Zuhilfenahme der vorhandenen Datenbankinformationen berechnet oder abgeschätzt werden. So kann beispielsweise eine Bodenfeuchtigkeit aus der Bodenbeschaffenheit und den Niederschlägen in der vergangenen Zeit bestimmt werden.

Üblicherweise werden die entsprechenden Datenbanken von einem Betreiber eines Energieversorgungsnetzes nicht selbst vorgehalten, sondern können von Drittanbietern, beispielsweise Anbietern von Wetterinformationssystemen oder Geoinformationssystemen, bezogen werden. Dem Betreiber des elektrischen Energieversorgungsnetzes obliegt es jedoch zumeist, aus diesen verfügbaren Datenbanken die Modellbeschreibung zu erzeugen. Es ist jedoch auch denkbar, dass die Modellbeschreibung von einem Drittanbieter erzeugt und dann dem Betreiber des Energieversorgungsnetzes zur Verfügung gestellt wird.

Figur 2 zeigt beispielhaft die Bildung einer Modellbeschreibung 28 für die Erdimpedanz entlang eines betrachteten Abschnitts einer elektrischen Energieversorgungsleitung unter Nutzung von in gängigen Datenbanken verfügbaren Informationen. Hierzu wird zunächst ein Höhenprofil der elektrischen Energieversorgungsleitung benötigt, um den genauen Verlauf des Abschnitts der elektrischen Energieversorgungsleitung in den drei Raumkoordinaten festzulegen. Ein solches Höhenprofil ist lediglich beispielhaft in Figur 2 mit den Bezugszeichen 21 gekennzeichnet. In dem Höhenprofil 21 ist die Höhe des Abschnitts über einer Referenzhöhe (üblicherweise dem Meeresspiegel) in Abhängigkeit von seiner Länge aufgetragen. Ein solches Höhenprofil kann beispielsweise unter Verwendung einer elektronischen Landkarte 22 des entsprechenden Bereiches, durch den der Abschnitt der elektrischen Energieversorgungsleitung führt, gewonnen werden, wobei in dieser elektronischen Landkarte 22 die Höheninformationen für den betroffenen Bereich angegeben sind. So sind in der elektronischen Landkarte 22 lediglich beispielhaft die Höhenlinien 22a, 22b, 22c herausgestellt worden, die verschiedene Höhenabschnitte in der elektronischen Landkarte 22 angeben.

Zum Abgleich dieser elektronischen Landkarte 22 mit den Höheninformationen mit dem Verlauf des Abschnitts der Energieübertragungsleitung muss ferner eine geographische Landkarte 23 hinzugezogen werden, aus der der Verlauf 23a des Abschnitts der elektrischen Energieversorgungsleitung hervorgeht. Durch Überlagerung der Informationen über den geographischen Verlauf des Abschnitts aus der elektronischen Landkarte 23 mit den Höheninformationen aus der elektronischen Landkarte 22 lässt sich das Höhenprofil 21 ableiten.

Als Einflussfaktor für die Erdimpedanz soll eine Bodenfeuchtigkeit betrachtet werden. Hierzu wird zunächst aus einer Datenbank eines Geoinformationssystems eine elektronische Landkarte 24, die die Bodenbeschaffenheit angibt, ausgelesen. Eine solche elektronische Landkarte 24 gibt die Bodenbeschaffenheit für verschiedene Bereiche der Landkarte an. Beispielsweise kann im Bereich 24a ein Sandboden vorherrschen, im Bereich 24b befindet sich ein Flusslauf, im Bereich 24c herrscht Lehmboden vor und im Bereich 24d befindet sich Granitgestein.

Um eine Aussage über die Bodenfeuchtigkeit zu erhalten, wird für das entsprechende Gebiet eine Wetterkarte 25 hinzugezogen, die die Niederschlagsmenge der vergangenen Zeit in dem betroffenen Areal angibt. So ist beispielsweise ein Bereich 25a von einer hohen Niederschlagsmenge, z.B. 25 Liter pro Quadratmeter während der letzten vier Wochen, betroffen, während ein Bereich 25b nur eine geringe Niederschlagsmenge aufweist.

Durch Kombination der elektronischen Landkarte 24 bezüglich der Bodenbeschaffenheit und der Wetterkarte 25 bezüglich der Niederschlagsmenge lässt sich eine weitere elektronische Landkarte 26 erzeugen, die die Bodenfeuchtigkeit für jede Position des betrachteten Bereiches angibt. Die größte Bodenfeuchtigkeit ist hierbei beispielsweise in einem Gebiet 26a, in dem sich der Wasserlauf befindet, sowie in einem Gebiet 26, in dem die hohe Niederschlagsmenge auf lehmigen Boden niedergegangen ist, zu finden.

Wiederum kann durch Überlagerung mit der Landkarte 23, die eine geographische Übersicht über das betroffene Gebiet mit dem genauen Verlauf des Abschnitts der elektrischen Energieversorgungsleitung angibt, ein Bodenfeuchtigkeitsverlauf 27 über die gesamte Länge des Abschnitts der elektrischen Energieversorgungsleitung bestimmt werden.

Aus der Kombination des Höhenprofils 21 und des Verlaufes der Bodenfeuchtigkeit 27 kann schließlich auf den Verlauf 28 der Erdimpedanz über die Länge des Abschnitts der elektrischen Energieversorgungsleitung geschlossen und damit die Modellbeschreibung erzeugt werden. Aus dieser Modellbeschreibung kann beispielsweise für einen Punkt des Abschnitts, der an der Länge $L_i$ zu finden ist, ein Wert der zugehörigen Erdimpedanz $\underline{Z}_{Ei}$ bestimmt werden. Durch Summation aller aus der Modellbeschreibung 28 hervorgehenden partiellen Erdimpedanzen kann schließlich die Erdimpedanz $Z_{E,ges}$ über die komplette Länge des Abschnitts der elektrischen Energieversorgungsleitung gebildet werden.

In Figur 2 wurde lediglich beispielhaft eine Auswahl relevanter Einflussfaktoren getroffen (Höhenprofil, Bodenfeuchtigkeit, Bodenbeschaffenheit). Es können jedoch selbstverständlich beliebige weitere Einflussfaktoren, die den Wert der Erdimpedanz beeinflussen, in die Betrachtung einbezogen werden. Beispielsweise könnte ein Temperaturverlauf im Boden anhand von Lufttemperaturen, Sonneneinstrahlung, Bewuchs, Verschattung und Bodenbeschaffenheit bestimmt werden.

Anhand der Figuren 3 und 4 soll erläutert werden, wie die Werte der Einflussfaktoren bzw. die Modellbeschreibung dem Distanzschutzgerät 11 (s. Figur 1) zugeführt werden.

Figur 3 zeigt hierzu ein erstes Ausführungsbeispiel eines elektrischen Distanzschutzgerätes 30, das eine Messwerterfassungseinrichtung 31 und eine Steuereinrichtung 32 aufweist. Mit der Steuereinrichtung 32 ist eine Kommunikationseinrichtung 33 verbunden. Die Kommunikationseinrichtung 33 ist über eine Kommunikationsverbindung mit einer entfernten Datenverarbeitungseinrichtung 34, bei der es sich beispielsweise um einen PC in einer Netzleitstelle handeln kann, verbunden.

Die entfernte Datenverarbeitungseinrichtung 34 hat Zugriff auf Datenbanken 35 und 36, die Werte von Einflussfaktoren zur Bestimmung der Modellbeschreibung angeben. Beispielsweise handelt es sich bei der Datenbank 35 um eine Wetterdatenbank, während die Datenbank 36 Bestandteil eines Geoinformationssystems ist. Natürlich können daneben auch weitere Datenbanken mit Angaben über weitere Einflussfaktoren vorgesehen sein.

Die entfernte Datenverarbeitungseinrichtung 34 bezieht von den Datenbanken 35 und 36 die positionsabhängigen Werte der Einflussfaktoren, also Werte, denen jeweils ein geografischer Positionswert zugeordnet ist.

Entsprechend der Erläuterungen zu Figur 2 erzeugt die entfernte Datenverarbeitungseinrichtung 34 daraus die Modellbeschreibung und überträgt diese an das Distanzschutzgerät 30. Um unnötigen Datenverkehr über die Kommunikationsverbindung zu vermeiden, kann eine solche Übertragung der Modellbeschreibung auch erst dann vorgenommen werden, wenn die Modellbeschreibung von der Steuereinrichtung 32 angefordert wird. Dies kann bevorzugt nach dem Auftreten eines Erdfehlers auf dem Abschnitt 10 der elektrischen Energieversorgungsleitung geschehen.

Figur 4 zeigt schließlich ein zweites Ausführungsbeispiel eines elektrischen Distanzschutzgerätes 40 mit einer Messwerterfassungseinrichtung 41 und einer Datenverarbeitungseinrichtung 42. Das zweite Ausführungsbeispiel gemäß Figur 4 unterscheidet sich von dem Ausführungsbeispiel gemäß Figur 3 dadurch, dass hierbei die Berechnung der Modellbeschreibung nicht von einer entfernten Datenverarbeitungseinrichtung vorgenommen wird. Vielmehr kann die Steuereinrichtung 42 über eine Kommunikationseinrichtung 43 und ein nur schematisch angedeutetes Kommunikationsnetzwerk 44 direkt auf Datenbanken 45 und 46 zugreifen und von diesen die Werte der Einflussfaktoren beziehen. In diesem Ausführungsbeispiel berechnet die Steuereinrichtung 42 also selbst die Modellbeschreibung. Dies kann jedoch nur bei Distanzschutzgeräten mit vergleichsweise rechenstarken Steuereinrichtungen geschehen.

Obwohl in de bisherigen Beschreibung immer explizit von einem Distanzschutzgerät gesprochen wurde, kann die im Rahmen der Erfindung auch eine das beschriebene Verfahren implementierende Software gesehen werden, die auf einer entsprechenden Gerätehardware, beispielsweise einem entsprechend eingerichteten PC, ausgeführt wird.

**Patentansprüche**

1. Verfahren zum Orten eines Erdfehlers auf einem Abschnitt (10) einer elektrischen Energieversorgungsleitung nach dem Distanzschutzprinzip, wobei beim Auftreten eines Erdfehlers auf dem Abschnitt

   - ein den in dem Abschnitt (10) fließenden Strom angebender Strommesswert erfasst wird;
   - ein die an dem Abschnitt (10) anliegende Spannung angebender Spannungsmesswert erfasst wird;
   - ein den entlang des Abschnitts (10) fließenden Erdstrom angebender Erdstrommesswert erfasst wird; und
   - mit den erfassten Messwerten ein Fehlerortwert berechnet wird, der den Ort des Erdfehlers auf dem Abschnitt (10) angibt, wobei dieser Fehlerortwert unter Verwendung der Leitungsimpedanz des Abschnitts (10) und der Erdimpedanz des entlang des Abschnitts (10) verlaufenden Erdreiches gebildet wird,
   **dadurch gekennzeichnet, dass**
   - der Wert der zur Bildung des Fehlerortwertes verwendeten Erdimpedanz dynamisch festgelegt wird, wobei
   - zur dynamischen Festlegung des Wertes der Erdimpedanz eine Modellbeschreibung herangezogen wird, die zumindest zwei Einflussfaktoren auf die Erdimpedanz berücksichtigt und den Verlauf des Wertes der Erdimpedanz über die gesamte Länge des Abschnitts (10) angibt.

2. Verfahren nach Anspruch 1,
   **dadurch gekennzeichnet, dass**

   - als Einflussfaktoren zumindest zwei Parameter aus folgender Auflistung verwendet werden: eine Luftfeuchtigkeit, eine Lufttemperatur, ein Ionisierungsgrad der Luft, eine Feuchtigkeit des betroffenen Erdreiches, eine Temperatur des betroffenen Erdreiches, eine Bodenbeschaffenheit des betroffenen Erdreiches, ein Abstand des Abschnitts (10) vom Erdreich.

3. Verfahren nach Anspruch 1 oder 2,
   **dadurch gekennzeichnet, dass**

   - die zumindest zwei verwendeten Einflussfaktoren gemessen und/oder berechnet werden.

4. Verfahren nach einem der vorangehenden Ansprüche,
   **dadurch gekennzeichnet, dass**

   - die zumindest zwei verwendeten Einflussfaktoren aus zumindest einer Datenbank (z.B. 35) entnommen werden, wobei die zumindest eine Datenbank (z.B. 35) eine Zuordnung von geografischen Positionswerten zu den jeweiligen Werten der Einflussfaktoren enthält.

5. Verfahren nach Anspruch 4,
   **dadurch gekennzeichnet, dass**

   - die in der zumindest einen Datenbank (z.B. 35) enthaltenen Werte der Einflussfaktoren in Echtzeit an die tatsächlichen Bedingungen angepasst werden.

6. Verfahren nach Anspruch 4 oder 5,
   **dadurch gekennzeichnet, dass**

   - die Modellbeschreibung durch Auswahl solcher Werte der Einflussfaktoren gebildet wird, die denjenigen geografischen Positionswerten zugeordnet sind, entlang denen sich der Abschnitt (10) erstreckt.

7. Verfahren nach einem der Ansprüche 4 bis 6,
   **dadurch gekennzeichnet, dass**

   - die zumindest eine Datenbank (z.B. 35) ein Geoinformationssystem und/oder eine Wetterdatenbank ist.

8. Verfahren nach einem der Ansprüche 4 bis 7,
   **dadurch gekennzeichnet, dass**

   - die Modellbeschreibung von einer entfernten Datenverarbeitungseinrichtung (34) gebildet wird und von der entfernten Datenverarbeitungseinrichtung (34) einer Steuereinrichtung (32) eines Distanzschutzgerätes (30) bereitgestellt wird, die den Fehlerortwert berechnet.

9. Verfahren nach Anspruch 8,
**dadurch gekennzeichnet, dass**

- die Modellbeschreibung erst dann von der entfernten Datenverarbeitungseinrichtung (34) an die Steuereinrichtung (32) übertragen wird, wenn die Steuereinrichtung (32) die Modellbeschreibung anfordert.

10. Verfahren nach Anspruch 9,
**dadurch gekennzeichnet, dass**

- die Steuereinrichtung (32) die Modellbeschreibung nach dem Auftreten eines Erdfehlers auf dem Abschnitt (10) anfordert.

11. Verfahren nach einem der Ansprüche 4 bis 7,
**dadurch gekennzeichnet, dass**

- ein Distanzschutzgerät (40), das an dem Abschnitt (10) angeordnet ist, die zumindest zwei verwendeten Einflussfaktoren von der zumindest einen Datenbank (z.B. 45) empfängt und
- eine Steuereinrichtung (42) des Distanzschutzgerätes (40) anhand der empfangenen Einflussfaktoren die Modellbeschreibung bildet.

12. Elektrisches Distanzschutzgerät (11) zur Erfassung und Ortung von Erdfehlern auf einem Abschnitt (10) einer elektrischen Energieübertragungsleitung mit

- einer Messwerterfassungseinrichtung (14) zum Erfassen von Strom- und Spannungsmesswerten sowie Erdstrommesswerten, die Werte des in dem Abschnitt (10) fließenden Stromes und der an diesem anliegenden Spannung sowie des entlang des Abschnitts fließenden Erdstromes angeben; und
- einer Steuereinrichtung (15), die mit den erfassten Messwerten einen Fehlerortwert berechnet, der den Ort des Erdfehlers auf dem Abschnitt angibt, wobei dieser Fehlerortwert unter Verwendung der Leitungsimpedanz des Abschnitts (10) und der Erdimpedanz des entlang des Abschnitts (10) verlaufenden Erdreiches gebildet wird;
**dadurch gekennzeichnet, dass**
- die Steuereinrichtung (15) zur Durchführung eines Verfahrens gemäß einem der Ansprüche 1 bis 8 eingerichtet ist.

**Claims**

1. Method for tracing a ground fault on a section (10) of an electrical power supply line using the distance protection principle, wherein, when a ground fault occurs on the section:

- a current measured value is detected which indicates the current flowing in the section (10);
- a voltage measured value is detected which indicates the voltage on the section (10);
- a ground current measured value is detected which indicates the ground current flowing along the section (10); and
- a fault location value is calculated using the detected measured values, indicating the location of the ground fault on the section (10), wherein this fault location value is formed using the line impedance of the section (10) and the ground impedance of the earth along the section (10),
**characterized in that**
- the value of the ground impedance which is used to form the fault location value is designed dynamically, wherein
- the value of the ground impedance is defined dynamically using a model description which takes account of at least two influencing factors on the ground impedance, and indicates the profile of the value of the ground impedance over the entire length of the section (10).

2. Method according to Claim 1,
**characterized in that**

- at least two parameters from the following list are used as influencing factors: air humidity, air temperature, level of ionization of the air, moisture in the relevant earth, temperature of the relevant earth, ground character of the relevant earth, distance between the section (10) and the earth.

3. Method according to Claim 1 or 2,
   **characterized in that**

   - the at least two influencing factors which are used are measured and/or calculated.

4. Method according to one of the preceding claims,
   **characterized in that**

   - the at least two influencing factors which are used are taken from at least one data base (for example 35), wherein the at least one data base (for example 35) contains an association between geographic position values and the respective values of the influencing factors.

5. Method according to Claim 4,
   **characterized in that**

   - the values of the influencing factors which are contained in the at least one data base (for example 35) are matched in real time to the actual conditions.

6. Method according to Claim 4 or 5,
   **characterized in that**

   - the model description is formed by selection of those values of the influencing factors which are associated with those geographic position values along which the section (10) extends.

7. Method according to one of Claims 4 to 6,
   **characterized in that**

   - the at least one data base (for example 35) is a geo-information system and/or a weather data base.

8. Method according to one of Claims 4 to 7,
   **characterized in that**

   - the model description is formed by a remote data processing facility (34) and is supplied by the remote data processing facility (34) to a control device (32) of a distance protection device (30), which calculates the fault location value.

9. Method according to Claim 8,
   **characterized in that**

   - the model description is transmitted from the remote data processing facility (34) to the control device (32) only when the control device (32) requests the model description.

10. Method according to Claim 9,
    **characterized in that**

    - the control device (32) requests the model description after the occurrence of a ground fault on the section (10).

11. Method according to one of Claims 4 to 7,
    **characterized in that**

    - a distance protection device (40), which is arranged on the section (10), receives the at least two influencing factors which are used from the at least one data base (for example 45) and
    - a control device (42) for the distance protection device (40) forms the model description on the basis of the received influencing factors.

**12.** Electrical distance protection device (11) for detecting and tracing ground faults on a section (10) of an electrical power transmission line having

- a measured value detection device (14) for detection of current and voltage measured values as well as ground current measured values, which indicate values of the current flowing in the section (10) and of the voltage on this section as well as the ground current flowing along the section;
- a control device (15), which uses the detected measured values to calculate a fault location value which indicates the location of the ground fault on the section, wherein this fault location value is formed using the line impedance of the section (10) and the ground impedance of the earth along the section (10);
**characterized in that**
- the control device (15) is designed to carry out a method according to one of Claims 1 to 8.

**Revendications**

**1.** Procédé de localisation d'un défaut à la terre sur un tronçon (10) d'une ligne d'alimentation en énergie électrique suivant le principe de la protection à distance, dans lequel, s'il apparaît une erreur à la terre sur le tronçon,

- on détecte une valeur de mesure du courant indiquant le courant passant dans le tronçon ( 10 ) ;
- on détecte une valeur de mesure de tension indiquant la tension s'appliquant au tronçon ( 10 ) ;
- on détecte une valeur de mesure du courant de terre indiquant le courant de terre passant le long du tronçon ( 10 ) ; et
- on calcule par les valeurs de mesure détectées une valeur de localisation de défaut, qui indique l'emplacement du défaut à la terre sur le tronçon ( 10 ), cette valeur de localisation du défaut étant formée en utilisant l'impédance de ligne du tronçon ( 10 ) et l'impédance de terre de la zone de terre s'étendant le long du tronçon ( 10 ),
**caractérisé en ce que**
- on fixe dynamiquement la valeur de l'impédance de terre utilisée pour la formation de la valeur de localisation du défaut, dans lequel,
- pour la fixation dynamique de la valeur de l'impédance de terre, on tire parti d'une description par modèle qui tient compte d'au moins deux facteurs ayant de l'influence sur l'impédance de terre et qui indique la variation de la valeur de l'impédance de terre sur toute la longueur du tronçon ( 10 ).

**2.** Procédé suivant la revendication 1,
**caractérisé en ce que**

- on utilise comme facteurs ayant de l'influence au moins deux paramètres de l'énumération suivante : une humidité de l'air, une température de l'air, un degrés d'ionisation de l'air, une humidité de la zone de terre concernée, une température de la zone de terre concernée, une propriété du sol de la zone de terre concernée, une distance du tronçon ( 10 ) à la zone de terre.

**3.** Procédé suivant l'une des revendications 1 ou 2,
**caractérisé en ce que**

- on mesure et/ou on calcule les au moins deux facteurs ayant de l'influence qui sont utilisés.

**4.** Procédé suivant l'une des revendications précédentes,
**caractérisé en ce que**

- on prélève les au moins deux facteurs ayant de l'influence qui sont utilisés dans au moins une base ( par exemple 35 ) de données, la au moins une base ( par exemple 35 ) de données contenant une affectation de valeurs de position géographique aux valeurs respectives des facteurs ayant de l'influence.

**5.** Procédé suivant la revendication 4,
**caractérisé en ce que**

- on adapte les valeurs des facteurs ayant de l'influence qui sont contenues dans la au moins une base ( par exemple 35 ) de données en temps réel aux conditions réelles.

**6.** Procédé suivant l'une des revendications 4 ou 5,
**caractérisé en ce que**

- on forme la description par modèle en sélectionnant des valeurs des facteurs ayant de l'influence qui sont affectées à des valeurs de position géographique le long desquelles s'étend le tronçon ( 10 ).

**7.** Procédé suivant l'une des revendications 4 à 6,
**caractérisé en ce que**

- la au moins une base ( par exemple 35 ) de données est un système de géoinformation et/ou une base de données d'intempéries.

**8.** Procédé suivant l'une des revendications 4 à 7,
**caractérisé en ce que**

- on forme la description par modèle par un dispositif ( 34 ) de traitement des données à distance et on le met à disposition par le dispositif ( 34 ) de traitement de données à distance d'un dispositif ( 32 ) de commande d'un appareil ( 30 ) de protection à distance, qui calcule la valeur de localisation d'erreur.

**9.** Procédé suivant la revendication 8,
**caractérisé en ce que**

- on ne transmet la description par modèle par le dispositif ( 34 ) de traitement de données à distance au dispositif ( 32 ) de commande que si le dispositif ( 32 ) de commande demande la description par modèle.

**10.** Procédé suivant la revendication 9,
**caractérisé en ce que**

- le dispositif ( 32 ) de commande demande la description par modèle après l'apparition d'un défaut de terre sur le tronçon ( 10 ).

**11.** Procédé suivant la revendication 4 à 7,
**caractérisé en ce que**

- un appareil ( 40 ) de protection à distance, qui est disposé sur le tronçon ( 10 ), reçoit les au moins deux facteurs ayant de l'influence qui sont utilisés de la au moins une base ( par exemple 45 ) de données et
- un dispositif ( 42 ) de commande de l'appareil ( 40 ) de protection à distance forme la description par modèle au moyen des facteurs ayant de l'influence qui sont reçus.

**12.** Appareil électrique de protection à distance pour la détection et la localisation de défauts de terre sur un tronçon ( 10 ) d'une ligne de transmission d'énergie électrique, comprenant

- un dispositif ( 14 ) de détection de valeurs de mesure pour la détection de valeurs de mesure de courant et de tension ainsi que de valeurs de mesure de courant de terre, qui indiquent les valeurs du courant passant dans le tronçon ( 10 ) et de la tension s'y appliquant ainsi que du courant de terre passant le long du tronçon ; et
- un dispositif ( 15 ) de commande, qui calcule par les valeurs de mesure détectées une valeur de localisation de défaut qui indique l'emplacement du défaut de terre sur le tronçon, cette valeur de localisation de défaut étant formée en utilisant l'impédance de ligne du tronçon ( 10 ) et l'impédance de terre de la zone de terre s'étendant le long du tronçon ( 10 ),
**caractérisé en ce que**
- le dispositif ( 15 ) de commande est agencé pour effectuer un procédé suivant l'une des revendications 1 à 8.

**FIG 1**

**FIG 2**

FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1739441 A1
- EP 2007006703 W